## Europäisches Patentamt
## European Patent Office
## Office européen des brevets

(19)

(11) Numéro de publication: **0 081 422**
**B1**

(12) # FASCICULE DE BREVET EUROPEEN

(45) Date de publication du fascicule du brevet:
03.07.85

(51) Int. Cl.⁴: **H 01 L 21/82,** H 01 L 27/26,
H 03 K 19/04

(21) Numéro de dépôt: 82402181.0

(22) Date de dépôt: 30.11.82

(54) Procédé collectif de fabrication de circuits logiques comportant au moins un transistor à effet de champ du type à faible tension de seuil, et une résistance saturable, et circuit logique réalisé par un tel procédé.

(30) Priorité: 09.12.81 FR 8123026

(43) Date de publication de la demande:
15.06.83 Bulletin 83/24

(45) Mention de la délivrance du brevet:
03.07.85 Bulletin 85/27

(84) Etats contractants désignés:
DE GB NL

(73) Titulaire: THOMSON-CSF, 173, Boulevard Haussmann,
F-75379 Paris Cedex 08 (FR)

(72) Inventeur: Arnodo, Christian, THOMSON-CSF
SCPI 173, bld Haussmann, F-75379 Paris Cedex 08 (FR)
Inventeur: Nuzillat, Gérard, THOMSON-CSF
SCPI 173, bld Haussmann, F-75379 Paris Cedex 08 (FR)

(74) Mandataire: Lepercque, Jean et al, THOMSON-CSF
SCPI 173, Bld Haussmann, F-75379 Paris Cedex 08 (FR)

(56) Documents cités:
FR - A - 2 449 369

IEEE TRANSACTIONS ON ELECTRON DEVICES, vol. ED-28, no. 5, mai 1981, pages 489-493, New York, USA MASAO IDA et al.: "Fabrication technology for an 80-ps normally-off GaAs MESFET logic"
MICROWAVE PROCEEDINGS 11TH EUROPEAN MICROWAVE CONFERENCE, 7-11 septembre 1981, pages 264-269, Microwave Exhibitions and Publishers Ltd., Kent, G.B. J. ARNOLD et al.: "Extenden frequency range GaAs MESEFETs using 0.3mum gate lengths"
IEE PROCEEDINGS-I, vol. 128, no. 4, août 1981, pages 144-147, Old Woking, G.B. J. MUN et al.: "High-yield process for GaAs enhancement-mode MESFET integrated circuits"
IEEE TRANSACTIONS ON ELECTRON DEVICES, vol.

(56) Documents cités: (suite)
ED-28, no. 2, février 1981, pages 149-154, New York, USA A. CHU et al.: "A 31-GHz monolithic GaAs mixer/preamplifier circuit for receiver applications"

## Description

L'invention concerne un procédé collectif de fabrication de circuits logiques comportant chacun au moins un transistor à effet de champ du type quasi normalement bloqué ou à faible tension de seuil, et au moins une résistance saturable intégrée sur le même substrat semi-conducteur que le transistor.

On connaît de façon classique les transistors à effet de champ dits normalement conducteurs («normally on» en anglais) et les transistors normalement bloqués («normally off» en anglais). Les premiers sont bloqués par déplétion, nécessitant une alimentation à double polarité et présentant en outre l'inconvénient d'une consommation de courant électrique à l'état de repos. Les seconds laissent passer le courant quand on applique une tension appropriée à la grille de commande: ils ne nécessitent pas une alimentation à double polarité et sont plus économiques, mais par contre difficiles à réaliser, à cause de la très faible épaisseur du canal de conduction en donnant lieu à un grand nombre de déchets de fabrication.

Une troisième catégorie de transistors à effet de champ, qui est intermédiaire entre les deux précédentes tout en se rapprochant de la deuxième, est constituée par les transistors quasi normalement bloqués ou à faible tension de seuil; ils sont bloqués pour une tension de seuil $V_T$ qui peut être positive ou négative, ce qui signifie que l'on admet une certaine dispersion dans la fabrication collective de ces transistors qui est par exemple la suivante:

$$- 0,2 \text{ V} \leqslant V_T \leqslant + 0,2 \text{ V}$$

ou

$$- 0,3 \text{ V} \leqslant V_T \leqslant + 0,3 \text{ V}$$

Les transistors quasi normalement bloqués ou à faible tension de seuil, que l'on désignera ci-après par l'abréviation T.F.S., sont plus faciles à fabriquer que les transistors normalement bloqués, mais moins faciles à fabriquer que les transistors normalement conducteurs. Ils sont situés entre ces deux catégories en ce qui concerne la consommation de courant. On sait réaliser de tels transistors T.F.S., et des circuits logiques les utilisant, par la technique exposée dans la demande de brevet de la Demanderesse FR-A-2449369, dans laquelle le transistor à effet de champ du type T.F.S. comporte une tranchée creusée par érosion ionique entre source et drain, la grille étant déposée au fond de cette tranchée. En outre les circuits logiques qui les utilisent comportent des résistances saturables constituées par deux contacts ohmiques déposés sur la couche active du transistor à effet de champ et séparés par une tranchée creusée par érosion ionique dans la couche active à une profondeur telle que, dans l'épaisseur restante de la couche active, il puisse se former, pour un champ électrique donné, de l'ordre du volt, un domaine dipolaire analogue à celui qui circule dans une structure à effet Gunn, mais qui est ici stationnaire, par suite de la très faible largeur de la tranchée (de l'ordre du micron), ce domaine apparaissant pour une valeur très faible de la tension existant aux bornes de la résistance saturable, tension de l'ordre du volt.

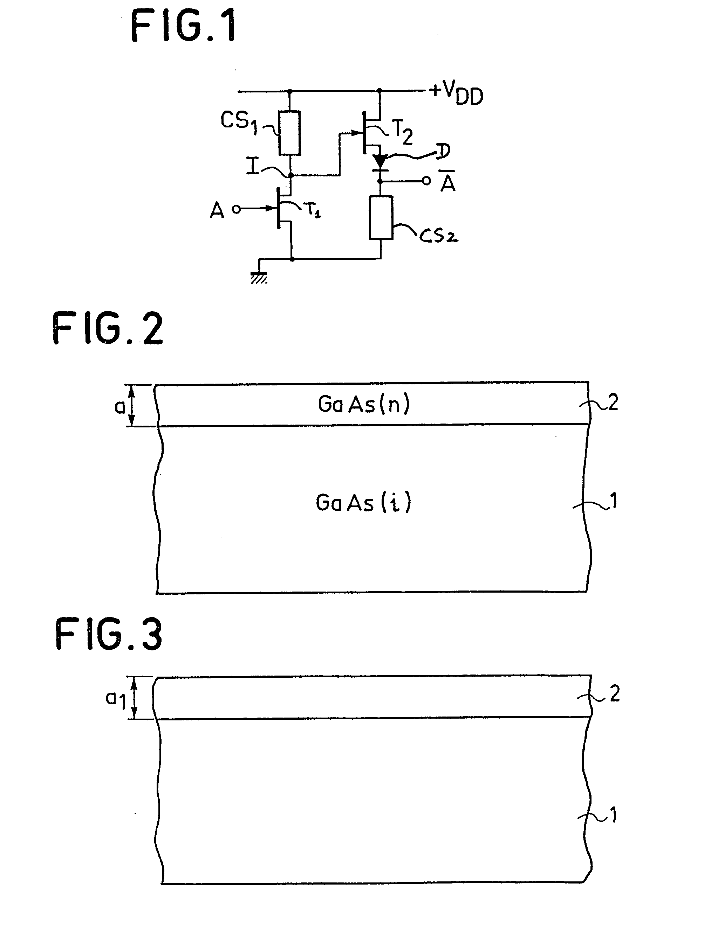

Un exemple de circuit logique comportant deux transistors T.F.S. et deux résistances saturables du type décrit ci-avant est représenté à la fig. 1.

Sur la fig. 1, on a représenté un inverseur logique dont l'entrée A est connectée à la grille d'un transistor $T_1$ qui est un T.F.S. Ce transistor a sa source à la masse, son drain connecté au point I connecté lui-même au point chaud correspondant à un pôle (positif dans cet exemple) d'une source $V_{DD}$ à travers une charge résistive $CS_1$. L'exemple choisi correspond au cas du transistor à canal n. Pour un canal p les polarités doivent être inversées.

Le point I est connecté à la grille d'un transistor $T_2$ qui est un T.F.S. Le transistor $T_2$ a son drain connecté au pôle $+V_{DD}$, sa source à une diode D, passante dans le sens allant de $+V_{DD}$ à la masse. Le retour à la masse s'effectue à travers une charge résistive $CS_2$ du même type que $CS_1$. La sortie $\overline{A}$ de l'inverseur est prise entre D et $CS_2$.

On rappelle brièvement les règles de fonctionnement de l'inverseur. Lorsque l'entrée A est à l'état «0» (potentiel nul ou légèrement positif), le transistor $T_1$ est bloqué ou quasi bloqué. Le potentiel au point I est voisin de celui du pôle $+V_{DD}$. La jonction grille-source du transistor $T_2$ étant polarisée en direct, le potentiel de la source tend à monter, de même que la sortie A, mais avec un décalage de tension dû à la diode. On a l'état «1» de la sortie, dont le potentiel est positif grâce à la présence de la charge résistive $CS_2$.

Lorsque l'entrée A est à l'état «1» (par exemple au voisinage de 0,8 V), le potentiel du point I est bas, de l'ordre de la tension de déchet du transistor $T_1$, et le transistor $T_2$ est par conséquent bloqué par sa grille. On montre que, grâce à la présence de la diode D, le potentiel de la sortie A est voisin de la masse (état «0»).

Un tel circuit logique pourrait fonctionner avec des résistances intégrées, même non saturables. Toutefois, les avantages suivants découlent de l'utilisation de résistances saturables:

1. diminution d'encombrement de la résistance pour une même valeur ohmique réalisée, d'où une diminution de la surface du circuit intégré et une économie de matériau semi-conducteur;

2. une diminution de la puissance fournie par la source d'alimentation électrique du circuit;

3. une amélioration du gain du transistor de la branche d'entrée du circuit logique (étage comportant le transistor $T_1$ et la résistance saturable $CS_1$);

4. meilleure protection contre le bruit et la dispersion des caractéristiques des transistors fabriqués collectivement sur une même rondelle de matériau semi-conducteur, due à l'amélioration de la caractéristique de transfert du circuit (caractéristique d'inversion dans le cas du circuit de la fig. 1).

Toutefois, la réalisation de résistances saturables de valeur précise, comportant une tranchée, représente une assez lourde sujétion technologique.

L'invention vise à s'affranchir d'une telle sujétion.

Le procédé de fabrication selon l'invention a pour but la fabrication collective de circuits logiques comportant chacun au moins un transistor à effet de champ à T.F.S. et une résistance saturable.

Il comporte les étapes suivantes:

a) Fabrication d'une plaquette semi-conductrice comprenant, sur un substrat semi-isolant, une couche active d'épaisseur au moins égale à une valeur prédéterminée;

b) érosion de la couche active, par un procédé d'attaque électro-chimique ou ionique, afin de diminuer l'épaisseur de celle-ci jusqu'à une valeur $a_1$ mesurée à l'aide de moyens électroniques;

c) isolement des zones de la plaquette destinées à recevoir respectivement chaque composant de circuit logique, en procédant par attaque mésa ou par implantation ionique de barrières isolantes;

d) dépôt des contacts ohmiques des transistors et des résistances saturables;

e) formation simultanée de contacts Schottky déposés entre les contacts ohmiques des résistances saturables et de dépôts métalliques recouvrant les contacts ohmiques pour faciliter les prises de contact électrique;

f) dépôt de métallisations raccordant l'un des contacts ohmiques de chaque résistance saturable et le contact Schottky réalisé à l'étape (e);

g) réalisation de la tranchée de chaque transistor à T.F.S. par érosion ionique à une profondeur $a_0$ calculée en fonction de l'épaisseur $a_1$ mesurée à l'étape (b);

h) dépôt des contacts Schottky dans le fond des tranchées réalisées à l'étape (g);

i) réalisation des interconnexions et connexions propres à chaque circuit logique.

L'invention sera mieux comprise, et d'autres caractéristiques apparaîtront, au moyen de la description qui suit, et des dessins qui l'accompagnent, parmi lesquels:

les fig. 1 et 9 représentent schématiquement des exemples de circuit logique (inverseur) dont celui de la fig. 9 est réalisé à l'aide du procédé selon l'invention;

les fig. 2 à 8 représentent, en coupes schématiques, différentes étapes du procédé selon l'invention.

La fig. 1, déjà décrite ci-avant, représente un inverseur logique d'entrée A et de sortie $\overline{A}$, présentant un premier étage comportant un transistor $T_1$ et une résistance saturable $CS_1$, et un étage de sortie comportant, outre un transistor $T_2$ et une résistance saturable $CS_2$, une diode redresseuse D.

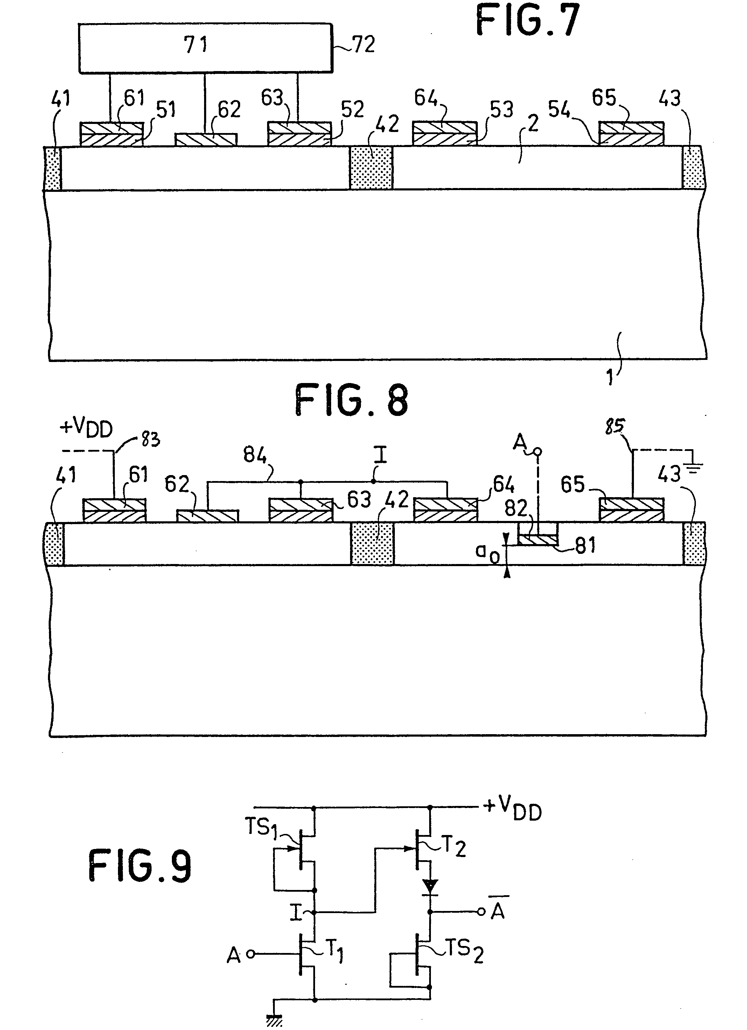

La fig. 9 représente le même type d'inverseur qu'à la fig. 1; mais dans lequel les résistances saturables sont réalisées sous la forme de transistors normalement passants $TS_1$ et $TS_2$ à grille reliée à la source.

Sur la fig. 2, on a représenté le stade obtenu à la fin de l'étape (a) du procédé selon l'invention. Une plaquette semi-conductrice en arséniure de gallium (représentée en coupe partielle transversale) comporte un substrat 1 et une couche active 2. Le substrat 1 est en arséniure de gallium isolant de dopage résiduel inférieur à $10^3$ atomes/cm³ (ou encore de résistivité supérieure à $10^7$ ω-cm). La

couche active 2, obtenue par exemple par épitaxie, est d'une épaisseur a supérieure à 250 nm (2500 Å) avec une variation maximale d'épaisseur de l'ordre de 10 nm (100 Å) sur 1 cm². Elle est dopée dans le type de conductivité n avec un taux de dopage de $10^{17}$ at/cm³ environ.

Sur la fig. 3, on a représenté le résultat obtenu à la fin de l'étape (b) au cours de laquelle on a procédé alternativement à l'attaque de la surface libre de la couche 2 pour diminuer l'épaisseur de celle-ci. Le résultat recherché est une épaisseur $a_1$ de l'ordre de 200 nm (2000 Å) avec un profil de dopage prédéterminé contrôlé à l'aide d'un appareil appelé couramment «profilomètre». L'attaque en surface est effectuée soit par oxydation anodique, soit par érosion ionique, soit par action d'un plasma spécifique du matériau. Le profilomètre permet de déterminer, par une mesure de capacité électrique, la profondeur de la zone déserte sous une tension continue de valeur prédéterminée. L'appareil de mesure permet de tracer la courbe (ou profil) de l'épaisseur de la zone déserte en fonction de cette tension.

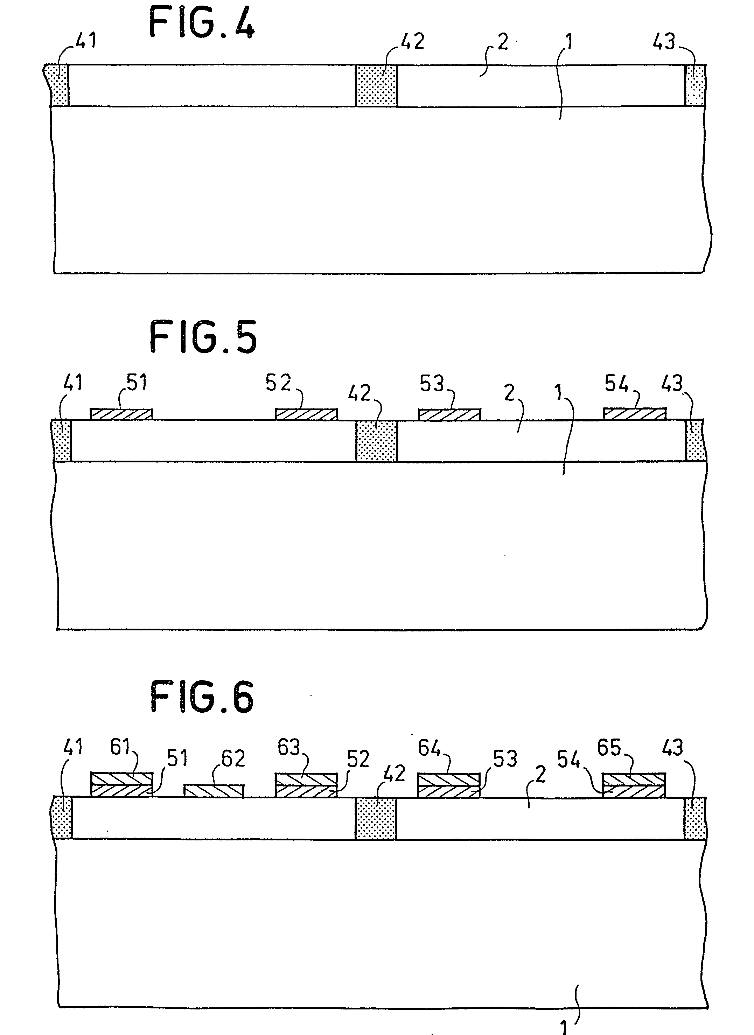

Sur la fig. 4 on a représenté le résultat obtenu à l'issue de l'étape (c) dans le cas d'implantation d'ions tels que $H^+$, $B^+$ et $O^+$ ayant pour effet de créer des défauts de très grande densité dans le réseau cristallin, formant ainsi des barrières isolantes 41, 42 et 43 prévues ici pour isoler les deux composants du premier étage d'un circuit tel que celui de la fig. 1 ou 9.

Sur la fig. 5 on a représenté le résultat obtenu à l'étape (d) du procédé, dans laquelle, par exemple à l'aide de résine photosensible, on a procédé à un masquage préalable de manière à effectuer des dépôts susceptibles de réaliser avec l'arséniure de gallium des contacts ohmiques (alliage or-germanium par exemple), formant ainsi les contacts 51 et 52 pour la résistance saturable, 53 et 54 pour le transistor à T.F.S.

On peut aussi procéder par implantation d'impuretés dopantes de manière à obtenir un dopage $n^+$ dans la couche superficielle d'arséniure de gallium destinée à former les contacts ohmiques, puis par dépôt d'un métal tel que le platine.

Sur la fig. 6, on a représenté le résultat obtenu à l'étape (e) par dépôts successifs de métaux tels que le titane, le platine et l'or. On obtient ainsi un contact Schottky 62 situé entre les contacts 51 et 52. Simultanément les contacts ohmiques de l'étape précédente reçoivent les mêmes dépôts métalliques d'où la formation de métallisations complémentaires 61, 63 sur les contacts 51 et 52, 64 et 65 sur les contacts 53 et 54.

A ce stade du procédé, on peut intercaler une étape supplémentaire de détermination plus précise par rapport à celle de l'étape (b), de l'épaisseur $a_1$ de la couche active. A cet effet on réalise sur un transistor de la plaquette dont le canal utilise l'épaisseur $a_1$ pris comme témoin, le montage représenté à la fig. 7. Un traceur de caractéristiques 71 est branché sur les contacts 61, 62 et 63 du transistor. Des caractéristiques obtenues on déduit la tension de seuil $V_T$ de ce transistor, laquelle est, comme il est connu, fonction de l'épaisseur $a_1$ et

du profil de dopage. En effet la tension $V_T$ est donnée en fonction de $a_1$ par la formule:

$$V_T = \varnothing_B - \frac{q \, N \, a_1^2}{2 \, \varepsilon_{sc} \, \varepsilon_0}$$

dans laquelle $\varnothing_B$ représente: la hauteur de barrière;

N: le nombre de porteurs de charge;

q: la charge de l'électron;

et où $\varepsilon_{sc}$ et $\varepsilon_0$ sont les constantes diélectriques relatives et absolues du semi-conducteur et de l'air.

Sur la fig. 8, on a représenté l'ensemble des résultats obtenus à l'issue des étapes (f) à (i). On trouve donc la tranchée 81 creusée par érosion ionique jusqu'à ce que l'épaisseur restante $a_0$ de la couche active soit telle que le transistor à effet de champ obtenu ultérieurement en déposant un contact Schottky soit du type à faible tension de seuil, c'est-à-dire que la tension de seuil $V_T$, mesurée par des moyens électriques connus, soit telle que l'on ait par exemple:

$$- 0,3 \text{ V} \leqslant V_T \leqslant 0,3 \text{ V}.$$

La valeur $a_0$ est déterminée en tenant compte des résultats des mesures effectuées à l'étape (b), et éventuellement à l'étape supplémentaire, intercalée après l'étape (e).

A l'étape (h) on dépose, par exemple par un procédé analogue à celui de l'étape (e), un contact Schottky 82 dans la tranchée 81.

Enfin les connexions du circuit logique sont réalisées à l'étape (i) sous la forme de métallisations 83 (joignant le drain 61 au pôle $+V_{DD}$ du circuit logique 84) reliant les contacts 62, 63 et 64, enfin 85 allant du contact 65 vers la masse.

## Revendications

1. Procédé de fabrication collective de circuits logiques comportant chacun au moins un transistor à effet de champ à faible tension de seuil et une résistance saturable, comportant les étapes suivantes:

a) fabrication d'une plaquette semi-conductrice comprenant, sur un substrat isolant (1), une couche active (2) d'épaisseur au moins égale à une valeur prédéterminée;

b) érosion de la couche active (2), par un procédé d'attaque électro-chimique ou ionique, afin de diminuer l'épaisseur de cette couche jusqu'à une valeur $a_1$ déterminée à l'aide de moyens électroniques;

c) isolement des zones de la plaquette destinées à recevoir respectivement chaque composant de circuit logique, en procédant par attaque mésa ou par implantation ionique de barrières isolantes (41, 42 et 43);

d) dépôt des contacts ohmiques des transistors (53 et 54) et des résistances saturables (51 et 52);

e) formation simultanée de contacts Schottky (62) déposés entre les contacts ohmiques des résistances saturables et de dépôts métalliques (61, 63, 64 et 65) recouvrant les contacts ohmiques;

f) dépôt de métallisations (84) raccordant l'un des contacts ohmiques de chaque résistance saturable avec le contact Schottky réalisé à l'étape (e);

g) réalisation de la tranchée (81) de chaque transistor à effet de champ à faible tension de seuil par érosion ionique à une profondeur $a_0$ calculée en fonction de l'épaisseur $a_1$ mesurée à l'étape (b);

h) dépôt des contacts Schottky (82) dans le fond des tranchées creusées à l'étape (g);

i) réalisation des interconnexions et connexions (83 et 85) propres à chaque circuit logique.

2. Procédé selon la revendication 1, dans lequel à l'étape (b) on procède alternativement à l'attaque de la surface libre de la couche active et au contrôle de l'épaisseur de cette couche active, ce dernier étant effectué en déterminant par une mesure de capacité électrique la profondeur de la zone déserte sous une tension de valeur prédéterminée.

3. Procédé selon la revendication 1, comportant une étape supplémentaire intercalée entre les étapes (e) et (f), au cours de laquelle on trace le réseau des caractéristiques de fonctionnement d'un transistor témoin du type à effet de champ dont l'épaisseur du canal est égale à l'épaisseur $a_1$, afin d'en déduire par l'intermédiaire de la tension de seuil, une valeur précise de l'épaisseur $a_1$.

4. Procédé selon la revendication 1, dans lequel à l'étape (g), on creuse la tranchée (81) jusqu'à ce que l'épaisseur restante $a_0$ de la couche active soit telle que le transistor à effet de champ présente une tension de seuil $V_T$ telle que l'on ait les inégalités suivantes:

$$- 0,3 \text{ V} \leqslant V_T \leqslant + 0,3 \text{ V}.$$

5. Circuit logique fabriqué par un procédé selon la revendication 1, dans lequel la ou les résistances saturables qu'il comporte est (ou sont) réalisée(s) sous la forme de transistor à effet de champ (TS$_1$, TS$_2$) dont la grille est directement connectée à la source.

6. Circuit logique selon la revendication 5, comportant un premier étage comprenant un transistor (T$_1$) dont la grille est reliée à l'entrée du circuit logique, en série avec une résistance saturable (TS$_1$), et un deuxième étage comprenant un transistor (T$_2$) dont la grille est reliée au point d'interconnexion du transistor et de la résistance du premier étage, en série avec une résistance saturable (TS$_2$), la sortie du circuit logique étant reliée au point d'interconnexion du transistor et de la résistance du deuxième étage.

## Patentansprüche

1. Verfahren zur Sammelherstellung von Logikschaltungen, die jeweils wenigstens einen Feldeffekttransistor mit niedriger Schwellspannung und einen sättigbaren Widerstand enthalten, mit den folgenden Schritten:

a) Herstellung eines Halbleiterplättchens, das auf einem isolierenden Substrat (1) eine aktive Schicht (2) umfasst, deren Dicke wenigstens gleich einem vorbestimmten Wert ist;

b) Erosion der aktiven Schicht (2) durch ein elektrochemisches oder Ionen-Ätzverfahren, um die Dicke dieser Schicht bis zu einem Wert $a_1$ zu

vermidern, der durch elektronische Mittel bestimmt wird;

c) Isolierung der Plättchenzonen, die jeweils zur Aufnahme eines Bauteils der Logikschaltung bestimmt sind, durch Mesaätzung oder durch Ionenimplantation von Isoliersperren (41, 42 und 43);

d) Ablagerung von ohmschen Kontakten der Transistoren (53 und 54) und der sättigbaren Widerstände (51 und 52);

e) gleichzeitige Bildung von Schottky-Kontakten (62),die zwischen den ohmschen Kontakten der sättigbaren Widerstände abgelagert sind, und von metallischen Ablagerungen (61, 63, 64 und 65), welche die ohmschen Kontakte bedecken;

f) Ablagerung von Metallisierungen (84), die einen der ohmschen Kontakte jedes sättigbaren Widerstandes mit dem Schottky-Kontakt verbinden, welcher im Schritt (e) gebildet wurde;

g) Herstellung des Grabens (81) jedes Feldeffekttransistors mit niedriger Schwellspannung durch Ionenerosion in einer Tiefe $a_o$, die in Abhängigkeit von der Dicke $a_1$ berechnet wurde, welche im Schritt (b) gemessen wurde;

h) Ablagerung von Schottky-Kontakten (82) am Grund der im Schritt (g) herausgearbeiteten Gräben;

i) Herstellung der Zwischenverbindungen und Verbindungen (83 und 85), die zu jeder Logikschaltung gehören.

2. Verfahren nach Anspruch 1, bei welchem im Schritt (b) abwechselnd die freie Oberfläche der aktiven Schicht geätzt wird und die Dicke dieser aktiven Schicht kontrolliert wird, wobei diese Kontrolle durchgeführt wird, indem durch eine elektrische Kapazitätsmessung die Tiefe der freiliegenden Zone unter einer Spannung von vorbestimmtem Wert bestimmt wird.

3. Verfahren nach Anspruch 1, mit einem zusätzlichen Schritt, der zwischen die Schritte (e) und (f) eingefügt wird und während welchem die Kennlinienfelder eines Prüftransistors vom Feldeffekttransistortyp aufgezeichnet werden, bei dem die Dicke des Kanals gleich der Dicke $a_1$ ist, um daraus über die Schwellspannung einen genauen Wert der Dicke $a_1$ abzuleiten.

4. Verfahren nach Anspruch 1, bei welchem im Schritt (g) der Graben (81) herausgearbeitet wird, bis die verbleibende Dicke $a_o$ der aktiven Schicht derart ist, dass der Feldeffekttransistor eine Schwellspannung $V_T$ von solchem Wert aufweist, dass folgende Ungleichungen gelten:
$$- 0,3 \,V \leqslant V_T \leqslant + 0,3 \,V.$$

5. Logikschaltung, die durch ein Verfahren nach Anspruch 1 ·hergestellt ist, bei welcher der darin enthaltene (die darin enthaltenen) sättigbare Widerstand (sättigbaren Widerstände) in Form eines Feldeffekttransistors $(TS_1, TS_2)$ verwirklicht ist (sind), wovon das Gate direkt mit der Sourceelektrode verbunden ist.

6. Logikschaltung nach Anspruch 5, mit einer ersten Stufe, die einen Transistor $(T_1)$ enthält, dessen Gate mit dem Eingang der Logikschaltung verbunden ist, in Reihe mit einem sättigbaren Widerstand $(TS_1)$, und eine zweite Stufe enthält, die einen Transistor $(T_2)$ umfasst, dessen Gate mit dem Verbindungspunkt zwischen Transistor und dem Widerstand der ersten Stufe verbunden ist, in Reihe mit einem sättigbaren Widerstand $(TS_2)$, wobei der Ausgang der Logikschaltung mit dem Verbindungspunkt zwischen dem Transistor und dem Widerstand der zweiten Stufe verbunden ist.

## Claims

1. Method for the collective fabrication of logic circuits each comprising at least one field-effect transistor of low threshold voltage and a saturable resistor, comprising the following steps:

a) fabrication of a semiconductor wafer comprising on an insulating substrate (1) an active layer (2) of thickness at least equal to a predetermined value;

b) erosion of the active layer (2) by an electrochemical or ion etching method to reduce the thickness of said layer up to a value $a_1$ determined by electronic means;

c) isolation of the wafer zones respectively intended to receive a component of the logic circuit by mesa etching or by ion implantation of insulating barriers (41, 42 and 43);

d) deposition of ohmic contacts of the transistors (53 and 54) and of the saturable resistors (51 and 52);

e) simultaneous formation of Schottky contacts (62), deposited between the ohmic contacts of the saturable resistors and of metallic depositions (61, 63, 64 and 65) which cover the ohmic contacts;

f) deposition of metallizations (84) connecting one of the ohmic contacts of each saturable resistor to the Schottky contact formed in step (e);

g) production of the trough (81) of each field-effect transistor of low threshold voltage by ion erosion to a depth $a_o$ calculated in dependence upon the thickness $a_1$ measured in step (b);

h) deposition of Schottky contacts (82) at the bottom of the troughs formed in step (g);

i) production of the interconnections and connections (83 and 85) belonging to each logic circuit.

2. Method according to claim 1 in which in step (b) alternately the free surface of the active layer is etched and the thickness of said active layer checked, said check being effected by determining by an electrical capacitance measurement the depth of the exposed zone under a voltage of predetermined value.

3. Method according to claim 1 comprising an additional step inserted between steps (e) and (f) during which the diagram of the operating characteristics of a sample transistor of the fieldeffect type is traced, the thickness of the channel of which is equal to the thickness $a_1$, in order to deduce therefrom via the threshold voltage an exact value of the thickness $a_1$.

4. Method according to claim 1 in which in step (g) the trough (81) is formed until the remaining thickness $a_o$ of the active layer is such that the field-effect transistor has a threshold voltage $V_T$ such that it satisfies the following inequations:

$- 0.3\,V \leqslant V_T \leqslant 0.3\,V.$

5. Logic circuit fabricated by a method according to claim 1 in which the saturable resistor or resistors contained therein is (are) realised in the form of a field-effect transistor ($TS_1$, $TS_2$) of which the gate is connected directly to the source electrode.

6. Logic circuit according to claim 5 comprising a first stage which includes a transistor ($T_1$) whose gate is connected to the input of the logic circuit in series with a saturable resistor ($TS_1$) and a second stage including a transistor ($T_2$) whose gate is connected to the interconnection point between transistor and the resistor of the first stage in series with a saturable resistor ($TS_2$), the output of the logic circuit being connected to the interconnection point between the transistor and the resistor of the second stage.

# FIG.1

# FIG.2

# FIG.3

# FIG.4

# FIG.5

# FIG.6

0 081 422

# FIG.7

# FIG. 8

+V$_{DD}$

A

# FIG.9

TS$_1$    T$_2$

T$_1$    TS$_2$

+V$_{DD}$

$\overline{A}$

A

11